# EUROPEAN PATENT APPLICATION

(11) **EP 4 478 851 A1**
(43) Date of publication of application: **18.12.2024**
(21) Application number: 23753263.5
(22) Date of filing: 08.02.2023
(51) Int. Cl.: H05K 7/20, B32B 9/00

(54) **HEAT TRANSFER MEMBER, AND HEAT TRANSFER ASSEMBLY AND ELECTRONIC DEVICE COMPRISING SAME**

(30) Priority: 08.02.2022 KR 20220016198
(71) Applicant: Amogreentech Co., Ltd., Gimpo-si, Gyeonggi-do 10014 (KR)
(72) Inventor: LEE, Hyo-Jung, Gimpo-si, Gyeonggi-do 10014 (KR); JEONG, Ui-Young, Gimpo-si, Gyeonggi-do 10014 (KR); JANG, Geunyoung, Gimpo-si, Gyeonggi-do 10014 (KR); LEE, Gyu Min, Gimpo-si, Gyeonggi-do 10014 (KR); SEO, In-Yong, Gimpo-si, Gyeonggi-do 10014 (KR); KIM, Jin Han, Gimpo-si, Gyeonggi-do 10014 (KR); KIM, Kyung Su, Gimpo-si, Gyeonggi-do 10014 (KR)
(74) Representative: Laine IP Oy
(86) International application number: PCT/KR2023/095004
(87) International publication number: WO 2023/153917

(57) **Abstract**

A heat transfer member is provided. A heat transfer member according to one embodiment of the present invention comprises a carbon-based sheet having an x-y plane, wherein the carbon-based sheet comprise: a heat transfer unit including a first part and a second part that are spaced apart from each other in an x-axis direction; and a shape deformation unit, located between the first part and the second part, that is bent by an external force which is applied so as to make the first part and the second part have different heights or plane directions. Due to this feature, the heat transfer member has excellent bending characteristics capable of connecting structures which are located on different planes or spaced apart from each other with a different in height without causing damage such as cracks. In addition, since the heat transfer member has excellent heat transfer characteristics, the heat transfer member can transfer heat very quickly from a structure having a heat source to another spaced-apart structure and release the heat to the outside, thereby minimizing performance degradation of an electronic device caused by heat generation.

## Description

### [Technical Field]

The present invention relates to a heat transfer member, and a heat transfer assembly and an electronic device including the same.

### [Background Art]

In recent years, electronic devices are employing various small and high-performance components in accordance with the trend toward high performance, multi-functionality, and lightness and miniaturization, but the amount of heat generated by the miniaturized and high-performance electronic components is increasing. Accordingly, preventing malfunction and damage to electronic components by effectively dissipating the large amount of heat generated in narrow spaces within electronic devices has become a very important task.

Accordingly, in recent electronic devices, there is a trend to increase the number of structures for heat dissipation, such as a heat dissipation plate, a heat sink, and the like, therein, but, as the size of various heat dissipation structures for heat dissipation is getting smaller due to the trend toward lightness and miniaturization, it is not sufficient to dissipate the heat generated from any heat generation source through a single heat dissipation structure disposed adjacent to the heat generation source.

In addition, since the internal structure of a light and miniaturized electronic device is very complex and narrow, when multiple heat dissipation structures are provided or a structure with a heat generation source and a heat dissipation structure are separated within a single electronic device, the multiple heat dissipation structures or the structure with a heat generation source and a heat dissipation structure adjacent thereto may be positioned on different planes or have height differences even when positioned on the same plane and spaced apart, so that it is not easy to quickly dissipate the large amount of heat generated in the electronic device in a short period of time by transferring heat from one structure to another structure positioned away from the structure.

In particular, in order to transfer heat between structures that are spaced apart from each other, a heat transfer member that mediates the structures is required, and when the structures that are spaced apart are positioned on different planes or have height differences, the heat transfer member has to have bending or folding properties, but a heat transfer member that has both excellent heat transfer characteristics and bending/folding properties has not yet been developed.

In other words, general heat dissipation sheets are usually manufactured from various metals in the form of sheets or carbon-based materials such as graphite in the form of sheets, which are known to have excellent thermal conductivity properties, but when the heat dissipation sheets have bending or folding properties, their heat dissipation performance is insufficient, and on the other hand, when the heat dissipation sheets have excellent heat dissipation performance, their bending or folding properties are insufficient or almost non-existent, so that there is a risk that damage such as cracks or the like may occur during bending or folding, and thus heat dissipation properties may deteriorate. In addition, in the case of a heat dissipation sheet in the form of a heat dissipation filler distributed inside a flexible polymer matrix, although the heat dissipation sheet has bending or folding properties, it is not suitable as a heat dissipation member for interconnecting spaced structures due to its poor heat transfer characteristics.

### [Disclosure]

### [Technical Problem]

The present invention has been made in consideration of the aforementioned problems, and is directed to providing a heat transfer member having excellent heat transfer characteristics and excellent bending properties, capable of connecting structures spaced apart from each other that are positioned on different planes or have height differences without causing damage such as cracks or the like, and a heat transfer assembly and an electronic device including the same.

### [Technical Solution]

In order to solve the aforementioned problem, one aspect of the present invention provides a heat transfer member including a carbon-based sheet having an x-y plane, in which the carbon-based sheet includes a heat transfer unit including a first part and a second part that are spaced apart from each other in an x-axis direction and a shape deformation unit that is positioned between the first part and the second part and bent by an external force applied so that the first part and the second part have different heights or surface directions.

According to one embodiment of the present invention, the heat transfer member may have the first part and the second part attached to correspond to a first surface and a second surface that are spaced apart from each other, respectively, so that one or more of the surface directions and the heights are different, and transfer heat from the first surface to the second surface.

In addition, the carbon-based sheet may include one or more of a natural graphite sheet, an artificial graphite sheet, and a graphene sheet.

In addition, the carbon-based sheet may have a thickness of 10 to 500 µm.

In addition, the shape deformation unit may have a length of 20 µm or more that is a length based on the x-axis direction.

In addition, the shape deformation unit may be provided with one or more of a plurality of holes and a plurality of grooves to impart bending properties to the carbon-based sheet.

In addition, a gap between adjacent holes or grooves may be 100 to 2,000 µm.

In addition, an area occupied by the plurality of holes may be 5 to 50% of the total area of the shape deformation unit.

In addition, an area occupied by the plurality of grooves may be 5 to 90% of the total area of the shape deformation unit.

In addition, the shape deformation unit having first and second surfaces facing each other in a thickness direction may include a plurality of grooves, some of the grooves may be formed in the first surface, and the remaining grooves may be formed in the second surface.

In addition, the grooves formed in the first surface and the grooves formed in the second surface may be formed so as not to correspond to each other.

In addition, a depth of the groove formed in the second surface may be deeper than a depth of the groove formed in the first surface.

In addition, the depth of the groove formed in the second surface may be 50 to 90% of a thickness of the shape deformation unit, and the depth of the groove formed in the first surface may be 10% or less of the thickness of the shape deformation unit.

In addition, one or more of the holes and grooves may be formed in a pattern that is symmetrical with respect to any one reference line parallel to a y-axis direction within the shape deformation unit.

In addition, the pattern may be formed so that a gap between adjacent holes or grooves increases from the reference line toward a boundary line between the shape deformation unit and each of the first part and the second part.

In addition, the heat transfer member may further include a cover member provided with a flexible film covering an exposed surface of the carbon-based sheet.

In addition, the heat transfer member may further include a cohesive member for attachment to an adherend surface on any one surface of each of the first part and the second part.

In addition, another aspect of the present invention provides a heat transfer assembly that transfers heat from one of a first structure and a second structure spaced apart from each other to the other structure, including the first structure having a first surface, the second structure having a second surface having one or more of a surface direction or a height different from the first surface, and the heat transfer member according to the one aspect of the present invention disposed so that a region corresponding to the first part is in contact with all or part of the first surface of the first structure on any one surface in a thickness direction and a region corresponding to the second part is in contact with all or part of the second surface of the second structure on the one surface or an opposite surface of the one surface.

According to one embodiment of the present invention, the first structure and the second structure may be each any one of a heat sink, a heat dissipation plate, a circuit board, a bracket, a display panel, a battery, and a housing.

In addition, still another aspect of the present invention provides an electronic device including the heat transfer assembly according to the present invention.

Hereinafter, a term used in the present invention is defined.

The term "bending" used in the present invention includes all of bending with a predetermined radius of curvature, fully bending so that one side is folded to meet another side, folding one side into two parts at a specific angle, or fully wrapping (e.g., rolling) with a predetermined radius of curvature.

### [Advantageous Effects]

According to the present invention, a heat transfer member has excellent bending properties capable of connecting structures spaced apart from each other that are positioned on different planes or have height differences without causing damage such as cracks or the like. In addition, since the heat transfer member has excellent heat transfer characteristics, the heat transfer member can transfer heat very quickly from a structure having a heat generation source to another structure that is spaced apart from the structure and release the heat to the outside, thereby minimizing the performance degradation of an electronic device due to heat generation.

### [Description of Drawings]

FIG. 1 is a plan view of a heat transfer member according to one embodiment of the present invention.
FIG. 2 is a cross-sectional view along a boundary line X-X' of FIG. 1.
FIGS. 3A and 3B are drawings of a heat transfer member according to one embodiment of the present invention, wherein FIG. 3A is a plan view and FIG. 3B is a cross-sectional view along a boundary line Y-Y' of FIG. 3A.
FIGS. 4A and 4B are cross-sectional views of heat transfer members according to various embodiments of the present invention.
FIGS. 5A to 5C are cross-sectional views of various shapes of holes capable of being formed in a heat transfer member according to one embodiment of the present invention.
FIGS. 6A and 6B are schematic views showing various hole patterns capable of being formed in a heat transfer member according to one embodiment of the present invention.
FIGS. 7A to 7C are usage state views of a heat transfer member according to one embodiment of the present invention.

### [Modes of the Invention]

Hereinafter, embodiments of the present invention will be described in detail with reference to the accompanying drawings so that those skilled in the art may easily perform the present invention. The present invention may be implemented in many different forms and is not limited to the embodiments described herein. In the drawings, in order to clarify the present invention, parts that are not related to description are omitted and like reference numerals represent like or similar elements throughout the specification.

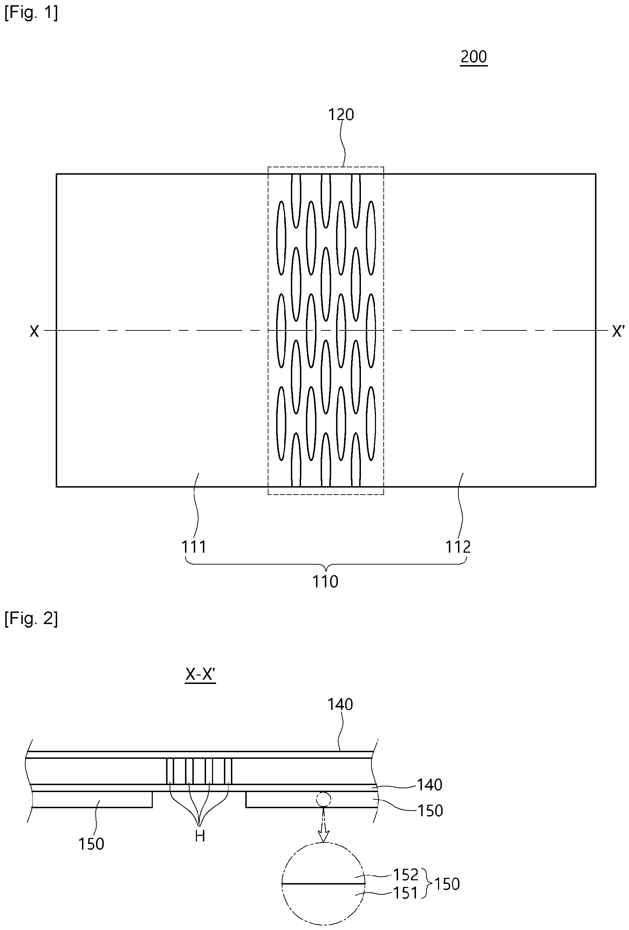

Referring to FIGS. 1 and 2, a heat transfer member 200 according to one embodiment of the present invention includes a heat transfer unit 110 and a shape deformation unit 20 formed in different regions within an integral carbon-based sheet having an x-y plane.

The heat transfer member 200 is a carbon-based sheet that is continuous in all directions within the x-y plane, and may exhibit very high horizontal heat transfer characteristics compared to metal sheets used as conventional heat dissipation members, thereby having the advantage of being able to quickly transfer heat from one side to the other between structures disposed spaced apart from each other. The carbon-based sheet may include one or more of a natural graphite sheet, an artificial graphite sheet, and a graphene sheet. In addition, the carbon-based sheet may be provided as one sheet of any one type of the aforementioned sheets or may have a form in which two or more sheets of one or more types of the sheets are stacked. In addition, the carbon-based sheet may be set to a thickness in a range of 10 to 500 µm. When the thickness is less than 10 µm, the mechanical strength is weak, so that the carbon-based sheet may be easily damaged by an applied external force, and when the thickness exceeds 500 µm, the carbon-based sheet may not be suitable since the carbon-based sheet may run counter to the trend toward lightness and miniaturization, and depending on a specific material of the carbon-based sheet, such as artificial graphite, it may not be easy to manufacture a single plate-shaped sheet with the thickness.

In addition, the heat transfer unit 110 includes a first part 111 and a second part 112, which are different regions spaced apart in an x-axis direction within the carbon-based sheet. The first part 111 and the second part 112 are parts that are in contact with specific surfaces of structures that are spaced apart, respectively, and perform a function of receiving heat through the specific surfaces or transferring heat to the specific surfaces.

In addition, the shape deformation unit 20 is positioned between the first part 111 and the second part 112 of the heat transfer unit 110 described above, and has a function of being bent by an external force applied so that the first part 111 and the second part 112 have different heights or surface directions.

That is, depending on the material, the first part 111 and the second part 112 may have difficulty in having sufficient strength or flexibility to withstand bending due to an applied external force, and may have even more difficulty in having folding properties based on a bending line that is an imaginary line that receives the greatest compressive force and tensile force within the shape deformation unit 20 when being bent. In particular, although the carbon-based sheet has excellent heat transfer characteristics in a horizontal direction compared to a metal sheet, the carbon-based sheet lacks the strength and flexibility to withstand bending, and thus may have difficulty in withstanding external forces generated as both ends of the carbon-based sheet are attached to structures spaced apart in various positions. However, the carbon-based sheet may be made to have bending properties by providing the shape deformation unit 20 between the first part 111 and the second part 112.

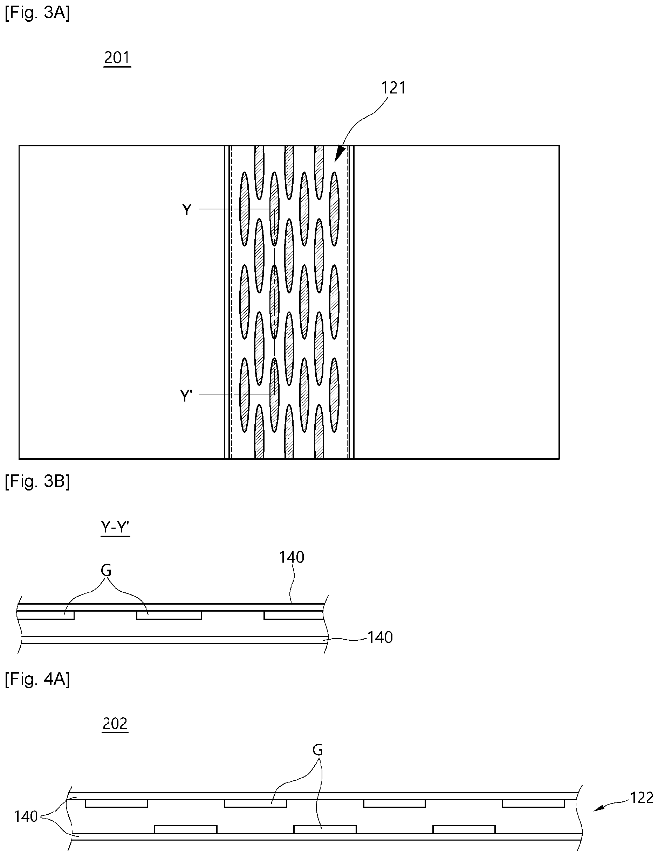

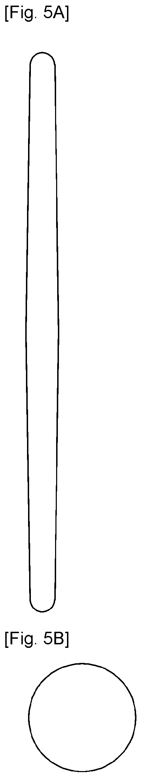

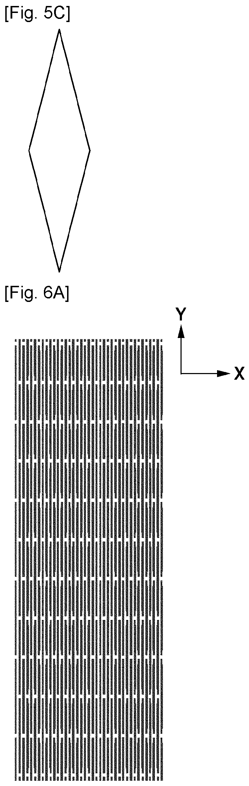

Meanwhile, in order to allow one specific region of a continuous carbon-based sheet in all directions in the x-y plane to have different shape deformation properties from other regions, a plurality of holes H may be formed in a shape deformation unit 120, or a plurality of grooves G may be formed in a shape deformation unit 121 of the heat transfer member 201 as shown in FIGS. 3A and 3B. The holes H are more advantageous in improving the bending properties compared to the grooves G, but the thermal conductivity properties may deteriorate due to punched portions. In contrast, since the grooves G are partially continuous in a thickness direction of the shape deformation unit 121 compared to the holes H, the bending properties may be improved while maintaining horizontal heat transfer characteristics almost the same. The holes H or grooves G may have a cross-sectional shape of a regular polygon or a closed curve or an irregular polygon or a closed curve, based on the thickness direction of the shape deformation unit 121 or 122. As one example, the cross-sectional shape may be implemented in a tapered shape that is elongated in one direction but becomes narrower as it goes toward the end as shown in FIG. 5A, a circle as shown in FIG. 5B, or a rhombus shape as shown in FIG. 5C. In this case, when an inner side is compressed and an outer side is stretched as the shape deformation unit is bended, the longer the shape of the hole H or groove G is extended perpendicularly to a direction of stretching, the more advantageous the hole H or groove G is for elongation, and in the case of the angular hole H or groove G such as the rhombus shape, since cracks are likely to occur due to local stress occurring at an angular portion during stretching, the hole H or groove G with a shape of a gentle curve may reduce the risk of crack occurrence while being better elongated, and thus, in this respect, the hole H or groove G of the shape shown in FIG. 5A may be advantageous compared to other shapes.

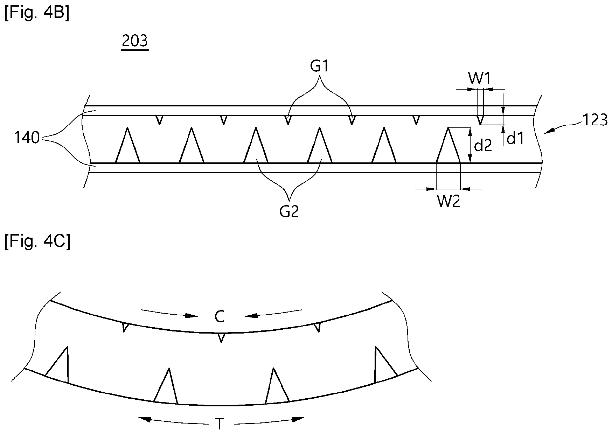

In addition, the longitudinal cross section of the hole H or groove G may be parallel to the thickness direction as shown in FIGS. 2 and 3B, but is not limited thereto, and may be formed to be inclined so that a width of the longitudinal cross section becomes narrower in the thickness direction as shown in FIGS. 4B and 4C.

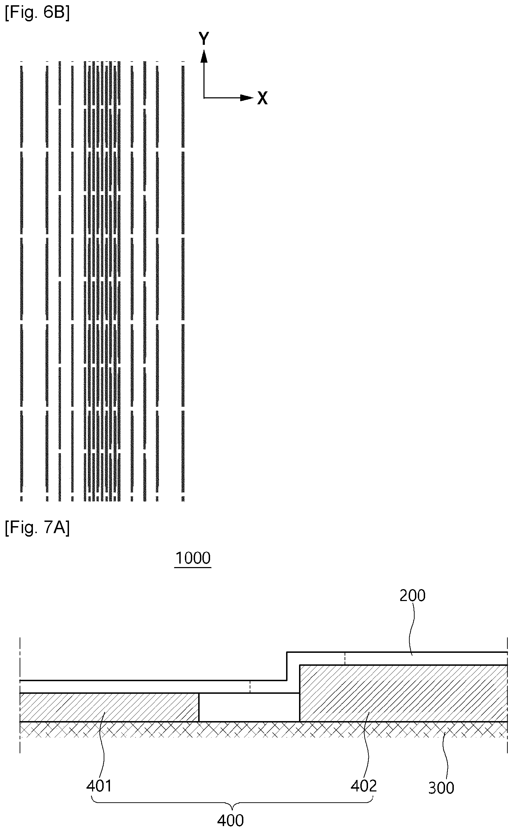

In addition, a plurality of holes H or grooves G may be formed, and in this case, the plurality of holes H or grooves G may be randomly formed regardless of their positions within the shape deformation unit 120 or 121, or may be formed in a predetermined pattern as shown in FIG. 6A or FIG. 6B, and as one example, one or more of the holes H or grooves G may have a pattern that is symmetrical with respect to a reference line parallel to a y-axis direction within the shape deformation unit 120 or 121.

In this case, considering a part that receives the greatest external force due to bending and a part that receives a less external force, the number and /or size of the holes H or grooves G, and/or gap between the holes H or grooves G may be formed differently depending on the region. As one example, as shown in FIG. 6B, each of the shape deformation units 120 and 121 may have a pattern formed so that the gap between adjacent holes H or grooves G increases from any one reference line parallel to the y-axis direction toward a boundary line between the shape deformation unit 120 or 121 and each of the first part 111 and the second part 112. Meanwhile, the boundary line refers to an imaginary line that is parallel to the y-axis direction and is positioned on the side of the first part 111 or the second part 112 among tangent lines that touch an edge of a hole H or groove G that is a reference point based on a hole H or groove G at the outermost position in the x-axis direction among the plurality of formed holes H or grooves G.

In addition, the grooves G may be formed in only one surface of the shape deformation unit 121 as shown in FIG. 3B, but may be formed in both surfaces of shape deformation units 122 and 123 as shown in FIGS. 4A to 4C. In this case, the size of each of the grooves G, G1, and G2 formed in both surfaces of the shape deformation units 122 and 123 may be the same or different from each other. In addition, the grooves formed in both surfaces of the shape deformation units 122 and 123 may be formed to completely correspond or partially correspond to each other in the thickness direction, but as shown in FIGS. 4A to 4C, the grooves G, Gi, and G₂ formed in both surfaces may be formed so as not to correspond to each other. In addition, considering the surface that is compressed and the surface that is stretched during bending, as shown in FIGS. 4B and 4C, the grooves G₁ and G₂ formed in both surfaces of the shape deformation unit 123 may be formed with different depths d₁ and d₂ and/or widths w₁ and w₂, and specifically, as shown in FIG. 4C, the depth d₁ and width w₁ of the groove G₁ in the surface that is compressed during bending may be formed to be smaller than the depth d₂ and width w₂ of the groove G₂ in the surface that is stretched, thereby providing an advantage of being able to respond to bending while minimizing the decrease in heat transfer characteristics.

Meanwhile, the holes H or groove G may be implemented using a known method capable of punching the carbon-based sheet or forming grooves using a cutter die, and as one example, the holes H or grooves G may be formed by emitting a laser beam and controlling an emission amount of the laser beam.

In this case, the formed holes H or grooves G may have a gap of 100 to 2,000 µm in the x-axis direction between adjacent holes H or grooves G, and through the gap, it may be advantageous to exhibit sufficient bending properties while preventing damage due to the applied external force.

In addition, an area occupied by the plurality of holes H may be 5 to 50% of the total area of each of the shape deformation units 120 and 121, when the holes H are formed in less than 5% of the area, the bending properties may not be sufficient, and when the holes H are formed in more than 50% of the area, there is a risk that damage such as cracks may occur or heat transfer characteristics may deteriorate. In addition, an area occupied by the plurality of grooves G may be 5 to 90% of the area of each of the shape deformation units 120 and 121, when the grooves G are formed in less than 5% of the area, the bending properties may not be sufficient, and when the grooves G are formed in more than 90% of the area, there is a risk that damage such as cracks may occur or heat transfer characteristics may deteriorate. Here, the total area of each of the shape deformation units 120 and 121 refers to the area of one surface within the region between the boundary line of the first part 111 and the boundary line of the second part 112, which have been described above.

In addition, the shape deformation units 120 and 121 may have a length of 20 µm or more, which is a distance between the boundary line of the first part 111 and the boundary line of the second part 112. When the length of the shape deformation units 120 and 121 is less than 20 µm, the applied external force may be received by the first part 111 or the second part 112 together, rather than the shape deformation units 120 and 121, so that there is a risk that damage such as cracks or the like may occur in the first part 111 or the second part 112.

In addition, each of the heat transfer members 200 and 201 may further include a cover member 140 that covers an exposed surface of the carbon-based sheet described above. The cover member 140 may be formed of a material having excellent flexible properties when bent while protecting the above-described carbon-based sheet from the outside, and the flexible film may be, for example, a film made of a thermoplastic elastomer resin such as thermoplastic polyurethane (TPU), thermoplastic polyamide elastomer (TPA), thermoplastic plastic copolyester (TPC), or the like, or a silicone-containing film. In addition, the cover member 140 may be provided to cover the whole surface of the heat transfer unit 110, and through the covering, fine powder that may be generated from the carbon-based sheet may be prevented from flying into the electronic device.

In addition, the polyurethane film may have a thickness of 5 to 50 µm. When the thickness of the polyurethane film is less than 5 µm, the polyurethane film may be easily torn by an external force, and thus may not sufficiently exert its protective function, and when the thickness thereof exceeds 50 µm, the bending and/or folding properties thereof may deteriorate.

In addition, the cover member 140 may be provided with a cohesive layer (or adhesive layer) for fixing the flexible film to the surface of the carbon-based sheet, and a known cohesionant or adhesive may be used, so the present invention is not particularly limited thereto. The cohesive layer (or adhesive layer) may be formed of an adhesive layer-forming composition containing an adhesive component containing, preferably at least one selected from the group consisting of acrylic resin, urethane resin, epoxy resin, silicone rubber, acrylic rubber, carboxyl nitrile elastomer, phenoxy and polyimide resin, more preferably acrylic resin, and even more preferably acrylic resin having heat resistance. In addition, the adhesive layer-forming composition may further contain a curing agent when the adhesive component is curable resin, and may further contain an additive such as a curing accelerator or the like depending on the purpose. The curing agent may be any curing agent without limitation as long as it is a commonly used curing agent in the art, and preferably, may contain at least one selected from the group consisting of an epoxy curing agent, a diisocyanate curing agent, a secondary amine curing agent, a tertiary amine curing agent, a melamine curing agent, an isocyanate curing agent, and a phenol curing agent, and more preferably, an epoxy curing agent. In addition, the cohesive layer (or adhesive layer) may have a thickness of 3 to 100 µm, preferably 5 to 15 µm.

In addition, the heat transfer member 200 may be provided with a cohesive member 150 for allowing each of the first part 111 and the second part 112 described above to be attached to an adherend surface on any one surface corresponding to each of the first part 111 and the second part 112. In this case, the cohesive member 150 may be provided with a cohesive layer 52 and a release film 51 for protecting the cohesive layer 52. In addition, the cohesive member 150 may include a double-sided cohesive tape having cohesive layers provided on both sides of a polymer substrate layer, unlike that shown in FIG. 2, and a release film attached to one of the cohesive layers of the double-sided cohesive tape.

In addition, as shown in FIG. 2, the cohesive member 150 may not be provided, for example, on all or part of any one surface corresponding to each of the shape deformation units 120 and 121 to prevent a decrease in the bending properties due to the cohesive member 150.

The heat transfer members 200 and 201 according to one embodiment of the present invention described above are useful as the heat transfer member that transfers heat from the first surface to the second surface so that the first part and the second part are attached to correspond to structures spaced apart from each other, particularly, the first surface of the first structure and the second surface of the second structure that are spaced apart from each other, respectively, so that one or more of the surface directions and the heights are different.

Accordingly, the present invention may implement a heat transfer assembly that transfers heat from one of the first and second structures, which are spaced apart from each other, to the other structure using the heat transfer members 200 and 201 described above.

Specifically, the heat transfer assembly is implemented to include the first structure having a first surface, the second structure having a second surface having one or more of a surface direction and a height different from the first surface, and a heat transfer member including a carbon-based sheet having an x-y plane, a heat transfer unit including a first part and a second part spaced apart in an x-axis direction that is in contact with a first surface of the first structure and a second surface of the second structure, respectively, and a shape deformation unit that is bent by an external force generated when the heat transfer unit is in contact with the first structure and the second structure.

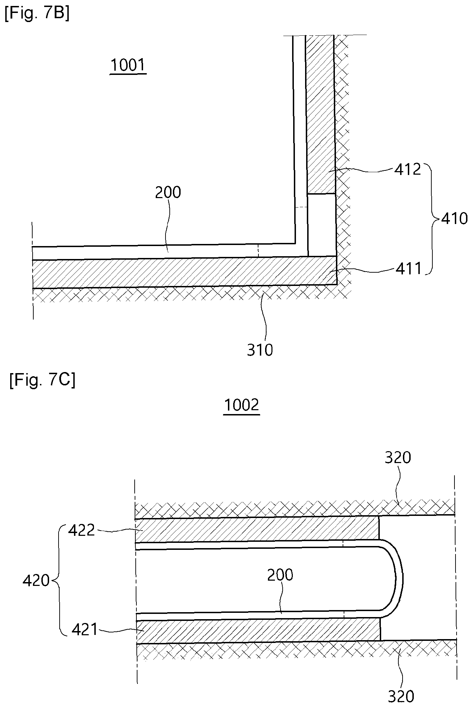

Describing heat transfer assemblies with reference to FIGS. 7A to 7C, heat transfer assemblies 1000, 1001, and 1002 respectively include structures 400, 410, and 420 including first structures 401, 411, and 421 and second structures 402, 412, and 422, which are spaced apart from each other, and the heat transfer members 200, and have each a heat dissipation structure in which the first part of the heat transfer member 200 is in contact with a corresponding one of the first structures 401, 411, and 421 and the second part of the heat transfer members 200 is in contact with a corresponding one of the second structures 402, 412, and 422, thereby transferring heat from any one of the first structure and the second structure to the other structure via the heat transfer member 200.

In particular, in a case in which the surface directions of the upper surfaces of the first structure 401 and the second structure 402 are the same, but there is a height difference between the structures, as shown in FIG. 7A, a case in which the surface directions of the upper surface of the first structure 421 and a lower surface of the second structure 422 are the same, but the structures exist on different planes, as shown in FIG. 7C, or a case in which the first structure 411 and the second structure 412 are in different surface directions and exist on different planes, as shown in FIG. 7C, when an external force is applied to the heat transfer members 200 attached to the first structures 401, 411, and 421 and the second structures 402, 412, and 422 at the same time, due to the bending properties of the heat transfer members 200, heat from any one of the first structures 401, 411, and 421 and the second structures 402, 412, and 422 may be easily transferred to the other structures without damage or breakage of the first and second parts of the heat transfer members 200.

In addition, it is to be noted that the first structures 401, 411, and 421 and the second structures 402, 412, and 422 may each independently be any one of a heat sink, a heat dissipation plate, a circuit board, a bracket, a display panel, a battery, and a housing, and that any known component constituting an electronic device that is not listed above may also be the structures.

Although the embodiments of the present invention have been described above, the spirit of the present invention is not limited by the embodiments presented in the present specification, and those skilled in the art who understand the spirit of the present invention will be able to easily suggest other embodiments by adding, changing, deleting, or supplementing components within the scope of the same spirit, but the other embodiments will also be considered to fall within the spirit of the present invention.

## Claims

1. A heat transfer member comprising a carbon-based sheet having an x-y plane,
wherein the carbon-based sheet comprises:
a heat transfer unit including a first part and a second part that are spaced apart from each other in an x-axis direction; and
a shape deformation unit that is positioned between the first part and the second part and bent by an external force applied so that the first part and the second part have different heights or surface directions.

2. The heat transfer member of claim 1, wherein the heat transfer member has the first part and the second part attached to correspond to a first surface and a second surface that are spaced apart from each other, respectively, so that one or more of the surface directions and the heights are different, and transfers heat from the first surface to the second surface.

3. The heat transfer member of claim 1, wherein the carbon-based sheet includes one or more of a natural graphite sheet, an artificial graphite sheet, and a graphene sheet.

4. The heat transfer member of claim 1, wherein the carbon-based sheet has a thickness of 10 to 500 µm.

5. The heat transfer member of claim 1, wherein the shape deformation unit has a length of 20 µm or more that is a length based on the x-axis direction.

6. The heat transfer member of claim 1, wherein the shape deformation unit is provided with one or more of a plurality of holes and a plurality of grooves to impart bending properties to the carbon-based sheet.

7. The heat transfer member of claim 6, wherein a gap between adjacent holes or grooves based on the x-axis direction is 100 to 2,000 µm.

8. The heat transfer member of claim 6, wherein an area occupied by the plurality of holes is formed to occupy 5 to 50% of the total area of the shape deformation unit,
an area occupied by the plurality of grooves is formed to occupy 5 to 90% of the total area of the shape deformation unit.

9. The heat transfer member of claim 6, wherein the shape deformation unit having first and second surfaces facing each other in a thickness direction includes a plurality of grooves, some of the grooves are formed in the first surface, and the remaining grooves are formed in the second surface.

10. The heat transfer member of claim 9, wherein the grooves formed in the first surface and the grooves formed in the second surface are formed so as not to correspond to each other.

11. The heat transfer member of claim 9, wherein a depth of the groove formed in the second surface is deeper than a depth of the groove formed in the first surface.

12. The heat transfer member of claim 11, wherein the depth of the groove formed in the second surface is 50 to 90% of a thickness of the shape deformation unit, and the depth of the groove formed in the first surface is 10% or less of the thickness of the shape deformation unit.

13. The heat transfer member of claim 6, wherein one or more of the holes and grooves are formed in a pattern that is symmetrical with respect to any one reference line parallel to a y-axis direction within the shape deformation unit.

14. The heat transfer member of claim 13, wherein the pattern is formed so that a gap between adjacent holes or grooves increases from the reference line toward a boundary line between the shape deformation unit and each of the first part and the second part.

15. The heat transfer member of claim 1, further comprising a cover member provided with a flexible film covering an exposed surface of the carbon-based sheet.

16. The heat transfer member of claim 1, further comprising a cohesive member for attachment to an adherend surface on any one surface of each of the first part and the second part.

17. A heat transfer assembly that transfers heat from one of a first structure and a second structure spaced apart from each other to the other structure, comprising:
the first structure having a first surface;
the second structure having a second surface having one or more of a surface direction and a height different from the first surface; and
the heat transfer member according to any one of claims 1 to 16 disposed so that a region corresponding to the first part is in contact with all or part of the first surface of the first structure on any one surface in a thickness direction and a region corresponding to the second part is in contact with all or part of the second surface of the second structure on the one surface or an opposite surface of the one surface.

18. The heat transfer assembly of claim 17, wherein the first structure and the second structure are each any one of a heat sink, a heat dissipation plate, a circuit board, a bracket, a display panel, a battery, and a housing.

19. An electronic device comprising the heat transfer assembly according to claim 17.
